# EUROPÄISCHE PATENTSCHRIFT

(11) **EP 0 807 258 B1**
(45) Veröffentlichungstag und Bekanntmachung des Hinweises auf die Patenterteilung: **19.01.2000**
(21) Anmeldenummer: 96902914.9
(22) Anmeldetag: 24.01.1996
(51) Int. Cl.: G01R 1/067, G01R 1/073

(54) **TESTVORRICHTUNG FÜR ELEKTRONISCHE FLACHBAUGRUPPEN**
TEST DEVICE FOR FLAT ELECTRONIC ASSEMBLIES
APPAREIL DE CONTROLE POUR ENSEMBLES ELECTRONIQUES PLATS

(30) Priorität: 02.02.1995 DE 19503329
(43) Veröffentlichungstag der Anmeldung: 19.11.1997
(73) Patentinhaber: ITA INGENIEURBÜRO FÜR TESTAUFGABEN GmbH, 22453 Hamburg (DE)
(72) Erfinder: BUKS, Manfred, D-24558 Henstedt-Ulzburg (DE); SCHALLER, Peter, 22043 Berlin (DE); KRÜGER, Jens, D-22889 Tangstedt (DE)
(74) Vertreter: Schaefer, Konrad, Dipl.-Phys.
(86) Internationale Anmeldenummer: EP9600280
(87) Internationale Veröffentlichungsnummer: WO9624069

(56) Entgegenhaltungen:
- EP-A- 0 458 280
- EP-A- 0 468 153
- US-A- 3 185 927

## Beschreibung

Die Erfindung betrifft eine Testvorrichtung der im Oberbegriff des Anspruchs 1 genannten Art.

Bekannte Testvorrichtungen dienen der Überprüfung elektronischer Flachbaugruppen unterschiedlichster Art. Solche Flachbaugruppen können beispielsweise bestückte oder unbestückte Leiterplatten sein oder zum Beispiel auf einem Wafer zu mehreren angeordnete hochintegrierte Schaltkreise zur IC-Herstellung. Auch die Prüfköpfe können unterschiedlichster Art sein, wie beispielsweise elektrische Kontaktspitzen, die über Relaisfelder an Stimulusquellen oder Meßverstärker einer geeigneten elektronischen Meßeinrichtung anschließbar sind oder sonstige für andere Prüfverfahren verwendete Prüfköpfe, wie beispielsweise induktive oder kapazitive Sensoren oder auch optische Abtaster, beispielsweise Kameras oder Mikroskope.

Zum schnellen Testen größerer Flachbaugruppen, wie beispielsweise Computer-Motherboards, sind meist mehrere Prüfköpfe vorgesehen, die unabhängig voneinander positionierbar sind. Mehrere Prüfköpfe sind häufig auch schon deswegen erforderlich, um bei gleichzeitigem Kontaktieren mehrerer elektrischer Knotenpunkte zum Beispiel an zwei Knotenpunkten eine Spannung anzulegen und an einem dritten Knotenpunkt eine Spannung abzugreifen. Die Steuerung der Prüfköpfe erfolgt zumeist an Hand von Ablaufprogrammnen, die individuell für eine bestimmte Flachbaugruppe erstellt werden.

Bekannte Testvorrichtungen dieser Art sind stets derart ausgebildet, daß alle Prülköpfe über die gesamte Fläche der maximal noch auf der Testvorrichtung testbaren Flachbaugruppe positionierbar sind. In üblicher Ausführung sind dabei die Prüfköpfe an Schlitten angeordnet, die mit Spindeln in X- und Y-Richtung über der Fläche der Flachbaugruppe verfahrbar sind. Im Falle auf- und abbewegbarer Kontaktspitzen sind an den Schlitten in Z-Richtung arbeitende Höhenantriebe vorgesehen.

Bei den bekannten Testvorrichtungen müssen die Schlittenführungen und -antriebe über die gesamte Länge der zu testenden Flachbaugruppe verfahrbar sein, also über erhebliche Längen, die bei einer typischen PC-Leiterplatte zum Beispiel 30 x 40 cm betragen. Bei diesen erheblichen Fahrwegen sind hohe räumliche Auflösungen erforderlich. So müssen beispielsweise die einzelnen Kontaktstifte moderner ICs mit einer Längenauflösung von weit unter 1/10 mm angesteuert werden. Daher sind äußerst stabile und schwere Lagerungen und Antriebe für die Schlitten erforderlich, die zu hohen bewegten Massen führen.

Nachteilig bei solchen Testvorrichtungen ist die aus den hohen bewegten Massen sich ergebende niedrige Fahrgeschwindigkeit von Punkt zu Punkt. Es müssen hohe Massen dauernd beschleunigt und gestoppt werden. Dabei müssen Ausschwingzeiten berücksichtigt werden.

Bei modernen Fertigungsstraßen, beispielsweise für elektronische Geräte, werden Flachbaugruppen aber in derartiger Geschwindigkeit hergestellt, daß bekannte Testvorrichtungen der gattungsgemäßen Art zu langsam sind. Es können daher nur einzelne ausgewählte Flachbaugruppen getestet werden oder es müssen mehrere Testvorrichtungen parallel verwendet werden.

Geschwindigkeitsvorteile weisen demgegenüber nichtgattungsgemäße Testvorrichtungen auf, die für jeden Rasterpunkt der Flachbaugruppe einen eigenen Prüfkopf vorhalten, die also mit stillstehenden Prüfköpfen arbeiten und die genannten Geschwindigkeitsprobleme nicht haben. Diese Testvorrichtungen sind jedoch schaltungstechnisch und preislich nachteilig und vor allem hinsichtlich ihrer festen Anordnung der Prüflinge. Sie sind daher nur für eine bestimmte, in Großserie gebaute Flachbaugruppe geeignet, während die gattungsgemäßen Testvorrichtungen mit ihren beweglichen Prüfköpfen zur raschen Umstellung auf verschiedene Flachbaugruppen geeignet sind, also zum Testen von Kleinserien.

Eine gattungsgemäße Testvorrichtung ist aus der EP-A-0 468 153, Fig. 4, bekannt. Gegenüber dem allgemeinen Stand der Technik weist diese Konstruktion zwei Besonderheiten auf.

An mehreren Quertraversen, die grundsätzlich über die gesamte Fläche der Flachbaugruppe verfahrbar sind, sind verfahrbare Schlitten vorgesehen, die jeweils einen Kopfantrieb in Form eines Schwenkhebels tragen, an dessen Ende ein höhenverstellbarer Kopf vorgesehen werden kann. Zum Positionieren des Prüfkopfes kann hierbei der Kopfantrieb durch Verschwenken des Schwenkarmes eingesetzt werden. Damit lassen sich aber nur Punkte auf einem Kreis um den Schlitten erreichen. Sollen alle Flächenpunkte der Flachbaugruppe erreichbar sein, muß zum Positionieren des Prüfkopfes sowohl der Kopfantrieb als auch der Schlittenantrieb und der Antrieb der verfahrbaren Quertraverse betätigt werden. Bei schneller Verstellung des Prüfkopfes genügt es also nicht, den leichten Kopfantrieb zu betätigen, sondern es müssen die schweren Schlitten und Quertraversen betätigt werden, also große Massen beschleunigt werden. Diese Konstruktion bietet also keine Geschwindigkeitsvorteile gegenüber dem zuvor zitierten allgemeinen Stand der Technik.

Eine weitere Besonderheit bei dieser bekannten Konstruktion ist die virtuelle Unterteilung der Gesamtfläche der Flachbaugruppe in Teilflächen, die von jeweils einer Quertraverse versorgt werden mit je zwei Schlitten und Kopfantrieben, also zwei Schlitten und Kopfantrieben pro Teilfläche. Auch hierdurch wird aber kein wesentlicher Geschwindigkeitsgewinn erreicht.

Aus der US-A-3 185 927 und der EP-A-0 458 280 sind Kopfantriebe bekannt, bei denen der Prüfkopf am Ende einer durch Verschwenken steuerbaren Nadel sitzt.

Die Aufgabe der vorliegenden Erfindung besteht darin, eine Testvorrichtung der eingangs genannten Art mit höherer Testgeschwindigkeit zu schaffen.

Diese Aufgabe wird erfindungsgemäß mit den Merkmalen des Kennzeichnungsteiles des Anspruchs 1 gelöst.

Bei dieser Bauweise bleibt der Vorteil der eingangs genannten Testvorrichtungen erhalten, eine auch größere Flachbaugruppe mit nur einem oder mit wenigen verfahrbaren Prüfköpfen testen zu können. Gegenüber den auf diesem Gebiet bekannten Testvorrichtungen besteht der Vorteil darin, daß ein Prüfkopf von einem Kopfantrieb über nur einer Teilfläche der Gesamtfläche der Flachbaugruppe angetrieben wird. Dadurch werden die Fahrwege verkürzt und es können bei gleicher oder besserer Steuerpräzision die bewegten Massen um Größenordnungen verringert werden. Daraus ergibt sich eine entsprechend um Größenordnungen erhöhbare Fahrgeschwindigkeit. Für bestimmte Anwendungsfälle, z.B. eine große Platine mit nur einem IC, reicht es aus, die Teilfläche in Größe des ICs vorzusehen. Die übrigen wenigen Testpunkte der Platine können auf andere Weise getestet werden. Sind mehrere Prüfköpfe mit entsprechenden Teilflächen vorgesehen, so können die Kopfantriebe zum Beispiel zwischen verschiedenen Teilflächen der Flachbaugruppe verfahrbar oder auch zu mehreren, die Gesamtfläche abdeckend, feststehend vorgesehen sein. Bei geringfügig erhöhtem mechanischen Aufwand ergibt sich eine durch die Verringerung der angetriebenen Massen erheblich erhöhte Testgeschwindigkeit, die auch für modernste Fertigungsstraßen ausreicht. Dabei gibt diese Konstruktion die Möglichkeit, durch Erhöhung der Anzahl der Prülköpfe und Kopfantriebe die Geschwindigkeit erheblich weiter zu erhöhen.

Vorteilhaft sind die Merkmale des Anspruches 2 vorgesehen. Bestückte elektronische Leiterplatten, der häufigste Testfall, sind heutzutage überwiegend mit ICs genormter Größe bestückt. Sind die Teilflächen den ICs angepaßt, so reicht es aus, Kopfantriebe über allen ICs zu positionieren bzw. einen oder mehrere Kopfantriebe von IC zu IC zu verfahren, um sämtliche zu erreichenden Testpunkte anfahren zu können.

Vorteilhaft sind die Merkmale des Anspruches 3 vorgesehen. Es können beispielsweise mehrere Kopfantriebe in einer Zeile angeordnet sein und von einem Hauptantrieb nacheinander quer zur Richtung der Zeile über eine größere Platine bewegt werden. Es können auch Kopfantriebe die gesamte Fläche einer zu testenden Baugruppe abdeckend stionär angeordnet sein, was insbesondere für kleinere zu testende Baugruppen von Vorteil sein kann. Bei letzterer Ausbildung sind sehr hohe, bisher nicht denkbare Testgeschwindigkeiten erreichbar.

Vorteilhaft sind die Merkmale des Anspruches 4 vorgesehen. Kopfantriebe können an den Schlitten bekannter Testvorrichtungen anstelle der bisher dort festangeordneten Prülköpfe vorgesehen sein und von den Hauptantrieben in größeren Schritten verfahren werden. Selbst wenn die Hauptantriebe, wie im Stand der Technik üblich, sehr langsam sind, so verlangsamt dies die Gesamttestzeit nicht wesentlich, da bei einem optimierten Testablaufprogramm dafür gesorgt werden kann, daß der Hauptantrieb nur wenige Schritte macht die wesentlich größere Anzahl der Testschritte aber von den sehr schnellen Kopfantrieben gemacht wird.

Vorteilhaft sind die Merkmale des Anspruches 5 vorgesehen. Ist der Prülkopf an einer schwenkbaren Nadel angeordnet, so kann er auch über die Grundfläche des Kopfantriebes hinaus verstellt werden. Es können also Kopfantriebe benachbart angeordnet werden, bei denen die Prüfköpfe im Grenzbereich zweier Kopfantriebe überlappend arbeiten können. Schwenkantriebe lassen sich beim heutigen Stand der Technik für die erforderliche Ansteuerelektronik sehr einfach und schnell ausbilden. Sie bieten den zusätzlichen Vorteil, mit schräggestellter Nadel schwer zugängliche Stellen erreichen zu können, beispielsweise solche, die nur seitlich, aber nicht direkt von oben zugänglich sind.

Vorteilhaft sind dabei die Merkmale des Anspruches 6 vorgesehen. Mit dieser Konstruktion läßt sich die Verschwenkung der Nadel sehr einfach mit zwei linearen Antrieben erreichen. Versuchsaufbauten haben sich als sehr robust und äußerst schnell erwiesen.

Prüfköpfe können beispielsweise optisch, kapazitiv oder auf sonstige Weise berührungslos arbeiten, wobei der Abstand zur zu prüfenden Oberflächenstelle der Flachbaugruppe unkritisch ist. Dann wäre ein Höhenantrieb für den Prülkopf nicht erforderlich. Zumindest bei elektrisch kontaktierenden, als Kontaktspitze ausgebildeten Prüfköpfen ist aber ein Höhenantrieb erforderlich, der die Kontaktspitze an jeder Prüfstelle absetzen und wieder hochheben muß. Bei solchen Testvorrichtungen sind vorteilhaft die Merkmale des Anspruches 7 vorgesehen. Durch Bewegen der Kontaktspitze gegenüber dem Kopfantrieb ergeben sich wiederum auch für diesen Antrieb sehr geringe Massen und hohe Stellgeschwindigkeiten.

Vorteilhaft sind dabei die Merkmale des Anspruches 8 vorgesehen. Hierdurch ist die Nadel sehr einfach im ganzen bewegbar ausgebildet.

Alternativ kann gemäß Anspruch 9 die Kontaktspitze gegenüber der Nadel bewegt werden. Dadurch wird die Nadel mechanisch aufwendiger, jedoch werden die bewegten Massen weiter verringert.

Vorteilhaft sind die Merkmale des Anspruches 10 vorgesehen. Dies schafft eine große Zahl von Variationsmöglichkeiten zur Geschwindigkeitesoptimierung. Weist beispielsweise eine bestückte Leiterplatte einige hochintegrierte ICs mit sehr engem Raster der zu kontaktierenden Anschlußpins auf, im übrigen aber beispielsweise eine Anzahl diskreter Bausteine mit gröberem Raster, so können kleinflächig arbeitende Kopfantriebe höchster Auflösung zum Anfahren der ICs vorgesehen sein und Kopfantriebe geringer Auflösung zum Anfahren der übrigen Konstaktstellen. Für diese übrigen Kontaktstellen können beispielsweise sogar von langsamen Hauptantrieben verfahrbare Prüfköpfe verwendet werden.

In den Zeichnungen ist die Erfindung beispielsweise und schematisch dargestellt. Es zeigen:
- Fig. 1:: einen Schnitt gemäß Linie 1 - 1 in Figur 2 durch eine Testvorrichtung,
- Fig. 2:: eine Draufsicht zu Figur 1,
- Fig. 3:: einen Vertikalschnitt durch einen der in der Testvorrichtung der Figuren 1 und 2 vorgesehenen Kopfantriebe,
- Fig. 4:: eine Draufsicht auf den Kopfantrieb der Figur 3,
- Fig. 5:: eine Draufsicht auf eine Testvorrichtung anderer Bauform mit sechs stationären Kopfantrieben,
- Fig. 6:: eine Seitenansicht zu Figur 5,
- Fig. 7:: eine Ansicht des unteren Endes der in Figur 3 dargestellten Nadel mit einem anderen Höhenantrieb und
- Fig. 8:: eine Ansicht des oberen Endes der in Figur 3 dargestellten Nadel mit einer weiteren Varante des Höhenantriebes.

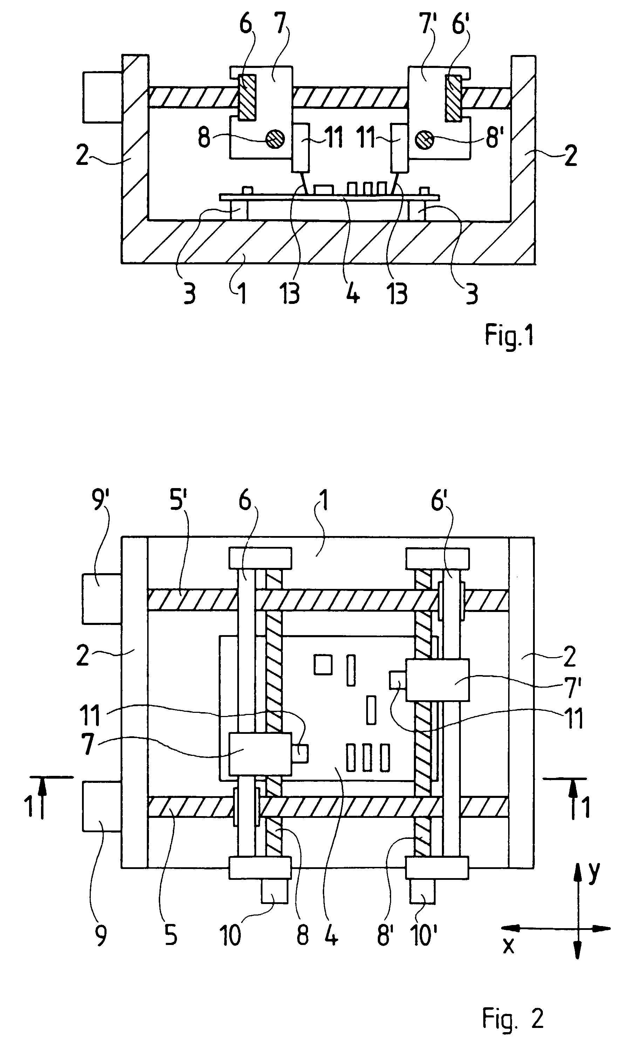

Die Figuren 1 und 2 zeigen eine Testvorrichtung mit zwei bewegten Prüfköpfen, die von im wesentlichen bekannter Bauart ist.

Ein Rahmen mit Grundplatte 1 und zwei Wangen 2 nimmt auf der Grundplatte 1 mit schematisch angedeuteten Halterungen 3 eine zu testende Leiterplatte 4 auf. Wie aus den Figuren zu ersehen, ist die Leiterplatte 4 mit einer Reihe von ICs oder sonstigen Bauelementen bestückt.

Zwischen den Wangen 2 erstrecken sich zwei Spindeln 5, 5' in einer im folgenden als X-Richtung bezeichneten Fahrrichtung. Auf diesen laufen Querbalken 6, 6', von denen der eine von der Spindel 5 und der andere von der Spindel 5' angetrieben ist. Auf den Querbalken 6, 6' laufen Schlitten 7, 7', die von parallel zu den Querbalken 6, 6' an diesen gelagerten Querspindeln 8, 8' in Y-Richtung angetrieben sind. Für die Spindeln 5, 5' sind Antriebsmotoren 9, 9' vorgesehen und für die Querspindeln 8, 8' Antriebsmotoren 10, 10'.

Mit dieser üblichen Testvorrichtung können die Schlitten 7, 7' durch entsprechende Ansteuerung der Motoren 9, 9', 10, 10' über jeden beliebigen Punkt der Leiterplatte 4 gefahren werden. Jeder der Schlitten 7, 7' trägt einen Kopfantrieb 11 für einen am Ende einer Nadel 13 angeordneten Prülkopf. In den Kopfantrieben 11 ist ein Höhenantrieb vorgesehen, mit dem die Nadeln 13 angehoben und abgesenkt werden können.

Leitungen von den Prüfköpfen zu einer nicht dargestellten elektronischen Testvorrichtung sind der zeichnerischen Vereinfachung wegen ebenso wie die elektronische Testvorrichtung weggelassen.

Mit der in den Figuren 1 und 2 dargestellten Testvorrichtung bekannter Bauart kann die Leiterplatte 4 zum Beispiel jeweils an zwei elektrischen Knoten kontaktiert werden und es kann beispielsweise der Durchgangswiderstand bestimmt werden.

Üblicherweise ist die dargestellte Testvorrichtung mit mehr Prüfköpfen ausgerüstet. Es können beispielsweise mehr als zwei Querbalken und an diesen jeweils mehrere Schlitten vorgesehen sein, so daß eine große Zahl von Prüfköpfen verwendbar ist.

Bekannte Testvorrichtungen der in den Figuren 1 und 2 dargestellten Art halten mit den als in X- und Y-Richtung starre Halter ausgebildeten Kopfantrieben 11 die Prüfköpfe in fester Position über der Fläche. Zu jeder Ortsverstellung einer der Prüfspitzen müssen daher die in X- und Y-Richtung vorgesehenen Antriebe verstellt werden. Bei den erforderlichen Fahrwegen von beispielsweise 60 cm in X-Richtung und 40 cm in Y-Richtung und bei den erforderlichen Positioniergenauigkeiten unter 1/10 mm ist die dargestellte Testvorrichtung sehr groß und schwer. Es treten hohe Beschleunigungskräfte auf. Die Fahrgeschwindigkeiten sind entsprechend niedrig.

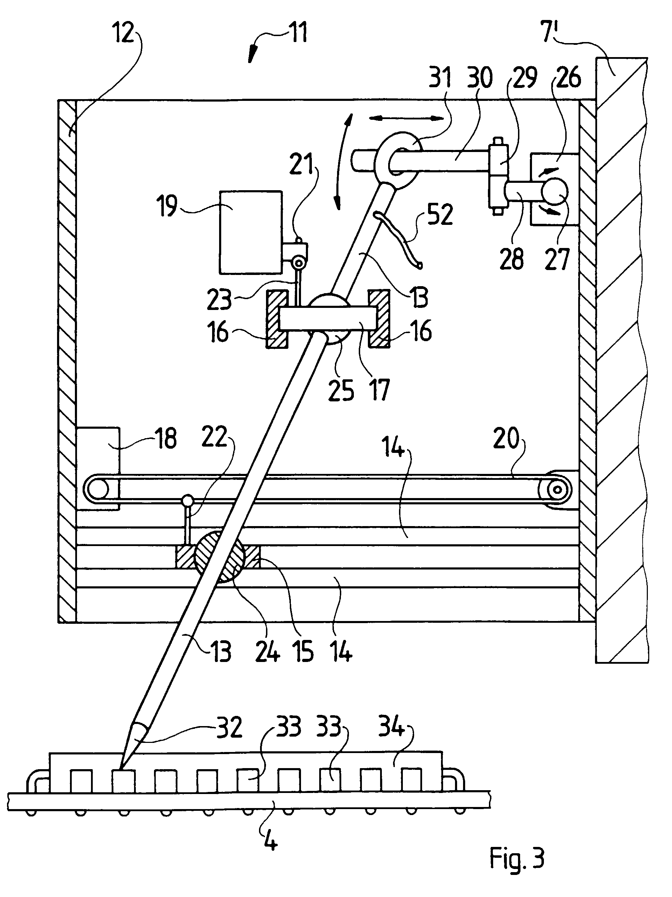

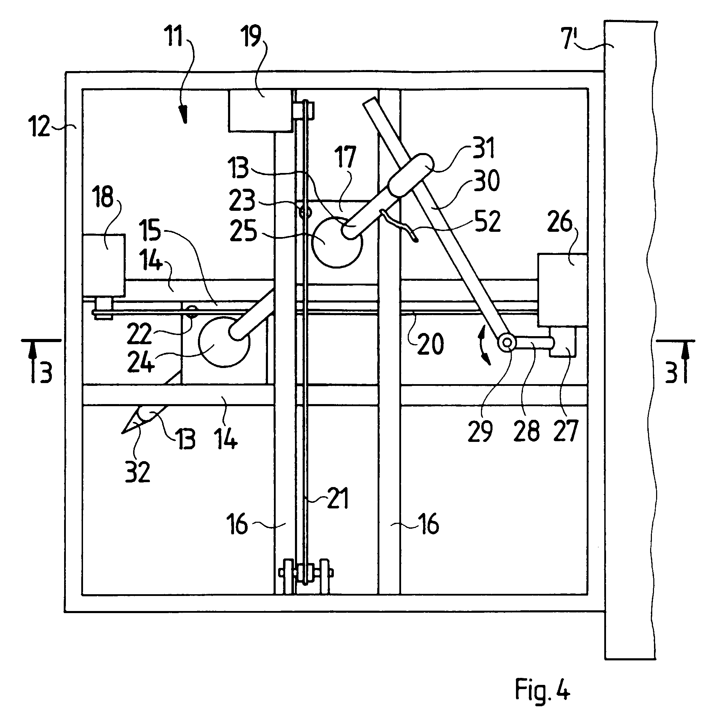

Um die Testgeschwindigkeit, also die mittlere Verfahrgeschwindigkeit eines Prüfkopfes zwischen zwei anzufahrenden Stellen auf der Leiterplatte 4 wesentlich herabzusetzen, sind die Kopfantriebe 11 vorgesehen. Im einzelnen ist dies an Hand der Figuren 3 und 4 erklärt.

Der Kopfantrieb 11 ist in einem Gehäuseschacht 12 ausgebildet, in dessen Inneren Antriebe für die Nadel 13 vorgesehen sind, die an ihrem unteren Ende als Prüfkopf eine Kontaktspitze 32 trägt.

Zunächst ist ein Antrieb zur Verstellung in X- und Y-Richtung, also in der Ebene der Leiterplatte 4, vorgesehen. Dieser weist einen in zwei Schienen 14 in X-Richtung verstellbaren Schlitten 15 auf und einen in Schienen 16 in Y-Richtung verstellbaren Schlitten 17. Die auf diese Weise in X- und Y-Richtung vorgesehenen Linearantriebe sind im Höhenabstand übereinander vorgesehen. Die Schlitten werden jeweils von Motoren 18 und 19 angetrieben, welche über umlaufende Endlosbänder 20, 21 und Mitnehmer 22, 23 die Schlitten 15, 17 treiben.

Jeder der Schlitten 15 und 17 trägt ein Kardanlager in Form einer in einer Kugelausnehmung des Schlittens allseitig drehbar gelagerten Kugel 24 und 25. Die Nadel 13 durchsetzt jeweils eine Bohrung der Kugel 24 bzw. 25 längsverschiebbar.

Durch Verstellung der Schlitten 15 und 17 mittels der Motoren 18 und 19 in X- bzw. Y-Richtung kann die Nadel 13 in beliebige Schwenkstellungen gebracht werden. Sie ist in den Kardanlagern der Kugeln 24, 25 längsverschiebbar. Ein Höhenantrieb sorgt für Höhenverstellung.

Der Höhenantrieb weist im dargestellten Ausführungsbeispiel einen am Gehäuseschacht 12 gelagerten Motor 26 auf, der über seine Abtriebswelle 27 einen Arm 28 in Pfeilrichtung (Fig. 3) schwenkt. Über ein Schwenklager 29 ist an dem Arm 28 ein Schwenkarm 30 gelagert, auf dem das obere Ende der Nadel 13 mit einem als Ring dargestellten Gleitlager 31 geführt ist.

Bei Verschwenkung durch die Schlitten 15 und 17 in X- und Y-Richtung wird die Nadel 13 jeweils um die Kugel 24 bzw. 25 des anderen Schlittens geschwenkt, so daß das obere Ende der Nadel 13 mit dem Gleitlager 31 entsprechend auslenkt. Durch die Verschiebbarkeit des Gleitlagers auf dem Schwenkarm 30 und dessen Verschwenkbarkeit um das Schwenklager 29 kann der Höhenantrieb den gesamten Schwenkbereich des oberen Endes der Nadel in dauerndem Eingriff zulassen.

Soll die Kontaktspitze 32 am unteren Ende der Nadel 13 definierte Höhenpositionen ausführen, so muß der dargestellte Höhenantrieb die Schwenklage der Nadel berücksichtigen. Dies kann über eine entsprechende Computeransteuerung des für den Höhenantrieb vorgesehenen Motors 26 erfolgen unter Berücksichtigung der jeweiligen Lage der in X- und Y-Richtung verschwenkenden Schlitten 15 und 17.

Wie Figur 3 im unteren Teil der Darstellung zeigt, kann die Nadel 13 mit ihrer Kontaktspitze 32 Anschlußbeine 33 eines ICs 34 nacheinander anfahren, die auf der Leiterplatte 4 verlötet sind.

Mit der insgesamt in den Figuren 1 bis 4 dargestellten Testvorrichtung wird die dargestellte Leiterplatte 4 mit einem Prüfprogramm getestet, das die Wege optimiert. Die Hauptantriebe mit den Motoren 9, 9', 10, 10' werden möglichst wenig benutzt. Sie verfahren jeweils die Kopfantriebe 11 in eine neue Position, in der diese durch die wesentlich schnellere Bewegung der leichten Nadel 13 sehr rasch eine sehr große Zahl von Punkten erreichen können, beispielsweise wie in Figur 3 dargestellt die verschiedenen Anschlußbeine 33 des ICs 34.

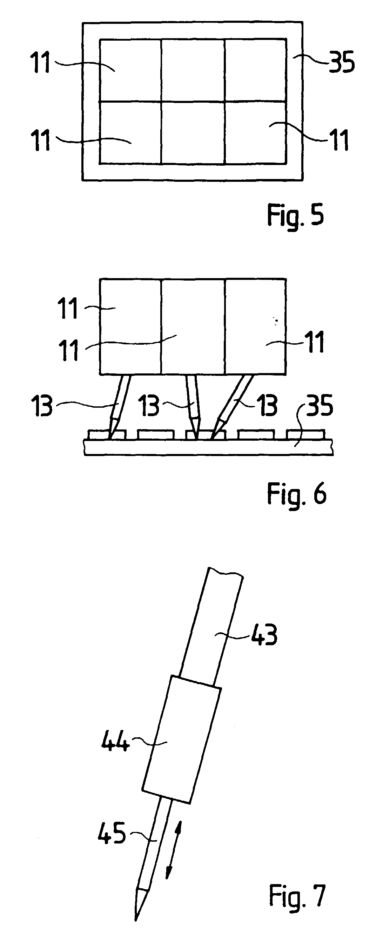

Die Figuren 5 und 6 zeigen eine grundsätzliche Ausführungsvariante, bei der mehrere der in den Figuren 3 und 4 dargestellten Kopfantriebe 11, und zwar im Ausführungsbeispiel sechs Stück in fester Anordnung aneinander befestigt und über einer zu testenden Leiterplatte 35 mit nicht dargestellten Haltern aufgestellt. Die dargestellten sechs Kopfantriebe 11 für die an Nadeln 13 ausgebildeten Prülköpfe stehen hier während des Testvorganges fest über der Leiterplatte 35. Es bewegen sich nur mit den an Hand der Figuren 3 und 4 erläuterten Antriebe die Nadeln 13, so daß sämtliche zu kontaktierenden Punkte auf der Leiterplatte 35 erreicht werden können. Eine solche Lösung eignet sich insbesondere für kleinere Leiterplatten.

In einer Variante kann beispielsweise eine Zeile aus mehreren nebeneinander angeordneten Kopfantrieben 11, wie in Figur 6 von der Seite zu sehen, als Zeile an einem der Querbalken 6, 6' der Testvorrichtung der Figuren 1 und 2 angeordnet sein. Durch Verfahren des jeweiligen Querbalkens mit dem in X-Richtung wirkenden Antrieb 5, 9 bzw. 5' 9' kann diese Zeile von Kopfantrieben über der Leiterplatte 4 verfahren werden.

Gegenüber den dargestellten Ausführungsformen sind eine Reihe weiterer Varianten möglich. Der in den Figuren 3 und 4 erläuterte Kopfantrieb 11 weist einen Höhenantrieb auf, der die Nadel 13 als Ganzes höhenverstellt. Alternativ kann gemäß Figur 7 eine Nadel 43 einen Höhenantrieb 44 tragen, der die Kontaktspitze 45 in Pfeilrichtung gegenüber der Nadel 43 verstellt. Dadurch kann durch Verringerung der höhenbewegten Massen der Höhenantrieb wesentlich beschleunigt werden. Es wird auch der in den Figuren 3 und 4 dargestellte Aufbau vereinfacht, da der dort dargestellte Höhenantrieb entfällt. Die Nadel 13 muß dann nicht mehr in beiden Kardangelenken, also in beiden Kugeln 24 und 25, längsverschiebbar gehalten sein. Sie kann in einer der Kugeln längsfest gehalten sein.

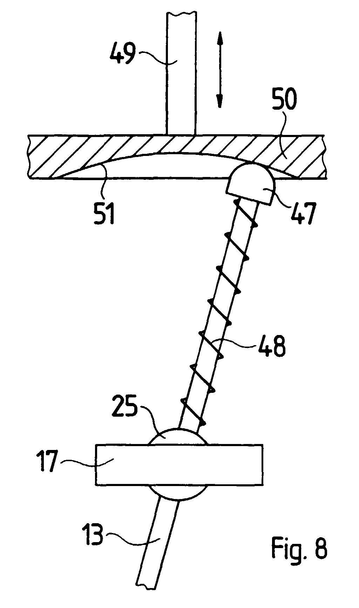

Figur 8 zeigt eine weitere Variante für den Höhenantrieb. Die Nadel 13 ist, wie gemäß den Figuren 3 und 4, längsverschiebbar in den Kugeln 24 und 25 geführt. Sie wird von ihrem oberen Ende her höhenangetrieben, jedoch mit einer anderen Antriebsart als in den Figuren 3 und 4 dargestellt.

Wie Figur 8 zeigt, ist ein Kopf 47 am oberen Ende der Nadel 13 mit einer Schraubenfeder 48 gegenüber dem Schlitten 17 abgestützt und drückt die Nadel 13 nach oben. Auf den Kopf 47 wirkt von oben eine von einem Antriebsorgan 49 parallel höhenverstellbare Platte 50, die gegen die Kraft der Feder 48 die Höhenverstellung der Nadel 13 besorgt.

Dabei kann die Platte 50 auf ihrer Unterseite eine ellipsoidkalottenförmige Ausnehmung 51 aufweisen, die in zwei Radien, passend zum Abstand um die Kugel 24 bzw. 25 ausgeformt ist. Dadurch läßt sich der Rechenaufwand für die Ansteuerung des Höhenantriebsmotors 26 verringern.

In der dargestellten bevorzugten Ausführungsform ist der Kopfantrieb für den Prüfkopf jeweils als Nadel-Schwenkantrieb ausgebildet. Dies hat, wie beispielsweise die Figur 6 zeigt, den Vorteil, daß der Prüfkopf am unteren Ende der Nadel 13 über die Grundfläche des jeweiligen Kopfantriebes 11 heraus, also zwischen benachbarten Kopfantrieben überlappend, verstellt werden kann. Vergleicht man Figur 2, so erkennt man, daß die beiden Kopfantriebe 11 seitlich nebeneinander gefahren werden können und im Grenzbereich überlappend arbeiten können.

Als Nadel-Schwenkantriebe können auch andere als die dargestellten Antriebe verwendet werden. So kann beispielsweise die Nadel um einen zentralen Schwenkpunkt mit geeigneten Antrieben geschwenkt werden. Sie kann auch oberhalb der in den Figuren 3 und 4 dargestellten Schlitten 15 und 17, beispielsweise an der Stelle des Gleitringes 31, also an ihrem oberen Ende, an einem ortsfesten Punkt schwenkbar gelagert sein. Die Schlitten 15 und 17 können dann die Nadel mit parallel zu ihren Schienen erstreckten Schlitzen fassen.

Es sei noch erwähnt, daß in dieser Beschreibung, die sich auf die mechanische Ansteuerung beschränkt, die elektrischen Anschlüsse der Kontaktspitze 32 weggelassen sind. Diese ist durch die Nadel 13 hindurch mit einem Anschlußleiter 52 elektrisch verbunden, welcher zu einer nicht dargestellten elektronischen Prüfeinrichtung führt. In dieser kann die Kontaktspitze 32 je nach Prüfsituation mit einem Meßverstärker oder einer Stimulusquelle, z.B. einer Konstantspannungsquelle oder einer Konstantstromquelle, verbunden werden. Zu den entsprechenden Testverfahren wird auf die entsprechende umfangreiche Literatur verwiesen. Es können z.B. Guard-Tests oder Parasitärtransistortests gemäß DE 41 10 551 C1 vorgenommen werden.

Die in den Ausführungsformen dargestellte Nadel 13 kann anstelle der dargestellten Kontaktspitze 32, die zur elektrischen Kontaktierung dient, auch andere Prülköpfe tragen, wie beispielsweise induktiv oder kapazitive Sensoren, die im Beispiel der Figur 3 mit den Beinen 33 nicht zu kontaktieren, sondern in definiertem Abstand zu diesen zu bringen sind. Als Prülköpfe können auch beispielsweise optische Einrichtungen, wie Kameras oder Mikroskope mit angeschlossener Videokamera, vorgesehen sein, mit denen hochauflösende Betrachtungen vorgenommen werden. Solche Einrichtungen können insbesondere in miniaturisierter Form zum Prüfen integrierter Schaltkreise auf Wafern verwendet werden.

Anstelle des bevorzugten, in den Figuren dargestellten Nadel-Schwenkantriebes für den Prüfkopf können als Kopfantriebe auch andere mechanische Antriebe vorgesehen sein. So sind beispielsweise einfache XY-Antriebe, wobei der X-Antrieb auf dem Y-Antrieb sitzt, verwendbar, mit denen eine beispielsweise nadelförmige Prüfspitze parallel verfahren wird. Außerdem sind in einer Ebene parallel zur zu prüfenden Leiterplatte überlagert schwenkende Antriebe verwendbar.

Die an Hand der Figuren 1 bis 4 erläuterte Testvorrichtung kann noch um einen zusätzlichen Grobhöhenantrieb ergänzt werden, über den die Kopfantriebe 11 an den Schlitten 7, 7' gehalten sind. Es kann sich dabei um langsame Höhenantriebe handeln, die nur für Sonderfälle verwendet werden, wenn beispielsweise unübliche Höhenbewegungen beim Überfahren eines größeren Bauteiles erforderlich sind, die von den Höhenantrieben im Kopfantrieb 11 nicht geleistet werden können.

## Patentansprüche

1. Testvorrichtung für elektronische Flachbaugruppen (4, 35) mit wenigstens einem über einer Teilfäche einer Baugruppe positionierbaren Kopfantrieb (11) zur unmittelbaren Verstellung eines Prüfkopfes (32, 45), **dadurch gekennzeichnet,** daß der Prüfkopf (32, 45) ohne Positionsänderung des Kopfantriebes (11) von diesem innerhalb der gesamten Teilfläche verstellbar ist.

2. Testvorrichtung nach Anspruch 1, **dadurch gekennzeichnet,** daß die Teilfläche Bauelementplätze (34) abdeckend ausgebildet ist.

3. Testvorrichtung nach Anspruch 1, **dadurch gekennzeichnet,** daß mehrere Kopfantriebe (11) mit ihren Prüfköpfen (32, 45) benachbarte Teilflächen abdeckend angeordnet sind.

4. Testvorrichtung nach Anspruch 1, **dadurch gekennzeichnet,** daß der Kopfantrieb (11) von Antriebselementen (7, 7') eines Hauptantriebes in der Fläche positionierbar angeordnet ist.

5. Testvorrichtung nach Anspruch 1, **dadurch gekennzeichnet,** daß der Prüfkopf (32, 45) am Vorderende einer langgestreckten Nadel (13, 43) angeordnet ist, die von dem Kopfantrieb (11) in ihrem Winkel gegenüber der Baugruppenfläche schwenkverstellbar gehalten ist.

6. Testvorrichtung nach Anspruch 5, **dadurch gekennzeichnet,** daß der Kopfantrieb (11) zwei in unterschiedlichem Abstand zur Baugruppenfläche angeordnete, in verschiedenen Richtungen (X, Y) parallel zu dieser verfahrbare Querantriebe (15, 17) aufweist, an denen die Nadel (13) jeweils kardanisch und an wenigstens einem Kardanlager (24, 25) längsverschiebbar gelagert ist.

7. Testvorrichtung nach Anspruch 5 mit Höhenantrieb des Prüfkopfes (32, 45) gegenüber der Baugruppenfläche, **dadurch gekennzeichnet,** daß der Prüfkopf (32, 45) von dem Höhenantrieb (26, 44) in Längsrichtung der Nadel (13, 43) verstellbar ist.

8. Testvorrichtung nach den Anspruch 6 und 7, **dadurch gekennzeichnet,** daß die Nadel (13) in beiden Kardanlagern (24, 25) längsverschiebbar gelagert ist und an ihrem dem Prüfkopf (32, 45) abgewandten hinteren Ende, von dem die Nadel (13) insgesamt in Längsrichtung verstellenden höhenantrieb (26, 30) beaufschlagt ist.

9. Testvorrichtung nach Anspruch 7, **dadurch gekennzeichnet,** daß der Prüftkopf (45) von dem an der Nadel (43) angeordneten Höhenantrieb (44) gegenüber der Nadel längsverstellbar ist.

10. Testvorrichtung nach Anspruch 1, **dadurch gekennzeichnet,** daß mehrere Kopfantriebe (11) unterschiedlicher räumlicher Auflösung vorgesehen sind.

## Claims

1. A test device for electronic board assemblies (4, 35) comprising at least one probe (32, 45) which, within the total area of an assembly, is positionable parallel to the surface by drive means, characterised in that the drive means comprise a probe drive (11) which, operating in all movement co-ordinates (X, Y) independently of the probe drives of other probes, positions the probe on a sub-area of the total area.

2. A test device according to claim 1, characterised in that the sub-area is constructed so as to cover component locations (34).

3. A test device according to claim 1, characterised in that a plurality of probe drives (11) are disposed so that their probes (13) cover adjacent sub-areas.

4. A test device according to claim 1, characterised in that the probe drive (11) is disposed to be positionable in the surface by drive elements (7, 7') of a main drive.

5. A test device according to claim 1, characterised in that the probe (32) is disposed at the front end of an elongate needle (13) which is mounted so as to be pivotable by means of the probe drive (11) in respect of its angle to the assembly surface.

6. A test device according to claim 5, characterised in that the probe drive comprises two transverse drives (15, 17) disposed at different distances from the assembly surface and movable in different directions (X, Y) parallel thereto, the needle (13) being mounted on said transverse drives in each case so as to be universally movable and longitudinally displaceable on at least one gimbal mount (24, 25).

7. A test device according to claim 5, with a vertical drive for the probe (32, 45) relatively to the assembly surface, characterised in that the probe (32, 45) is movable in the longitudinal direction of the needle (13) by the vertical drive (26, 44).

8. A test device according to claims 6 and 7, characterised in that the needle (13) is mounted for longitudinal displacement in both gimbal mounts (24, 25) and is subjected, at its rear end remote from the probe (32), to the action of the vertical drive (26, 30), which moves the needle (13) in its entirety in the in the longitudinal direction.

9. A test device according to claim 7, characterised in that the probe (45) is longitudinally movable relatively to the needle by means of the vertical drive (44) disposed on the needle (43).

10. A test device according to claim 1, characterised in that a plurality of probe drives having different spatial resolution are provided.

## Revendications

1. Dispositif de test de modules électroniques plats (4, 35) avec au moins un entraînement de tête (11) pouvant être positionné au-dessus d'une surface partielle d'un module afin d'assurer le déplacement direct d'une tête d'essai (32, 45), **caractérisé en ce que** la tête d'essai (32, 45) peut, sans changement de position de l'entraînement de tête (11), être déplacée par celui-ci sur la totalité de la surface partielle.

2. Dispositif de test selon la revendication 1, **caractérisé en ce que** la surface partielle est configurée de façon à recouvrir les emplacements des composantes (34).

3. Dispositif de test selon la revendication 1, **caractérisé en ce que** plusieurs entraînements de tête (11) avec leurs têtes d'essai (32, 45) sont agencés de façon à couvrir des surfaces partielles contiguës.

4. Dispositif de test selon la revendication 1, **caractérisé en ce que** l'entraînement de tête (11) est agencé de façon à pouvoir être positionné en surface par des éléments moteurs (7, 7') d'un entraînement principal.

5. Dispositif de test selon la revendication 1, **caractérisé en ce que** la tête d'essai (32, 45) est disposée à l'extrémité avant d'une aiguille allongée (13, 43) maintenue par l'entraînement de tête (11) de façon à pouvoir la faire pivoter en variant l'angle qu'elle forme avec la surface du module électronique.

6. Dispositif de test selon la revendication 5, **caractérisé en ce que** l'entraînement de tête (11) présente deux entraîneurs transversaux (15, 17) placés à différentes distances de la surface du module électronique et déplaçables parallèlement à celle-ci selon différentes directions (X, Y), et à chacun desquels l'aiguille (13) est maintenue par un logement de type Cardan avec une possibilité de déplacement longitudinal au niveau d'au moins un palier de Cardan (24, 25).

7. Dispositif de test selon la revendication 5 muni d'un organe de déplacement en hauteur de la tête d'essai (32, 45) par rapport à la surface du module électronique, **caractérisé en ce que** la tête d'essai (32, 45) est ajustable dans le sens longitudinal de l'aiguille (13, 43) par l'organe de déplacement en hauteur (26, 44).

8. Dispositif de test selon les revendications 6 et 7, **caractérisé en ce que** l'aiguille (13) est logée de façon à pouvoir être décalée longitudinalement dans les deux paliers de Cardan, et est actionnée à son extrémité arrière opposée à la tête d'essai (32, 45) par l'organe de déplacement en hauteur (26, 44) qui assure l'ajustage longitudinal global de l'aiguille (13).

9. Dispositif de test selon la revendication 7, **caractérisé en ce que** la tête d'essai (45) peut être déplacée longitudinalement par rapport à l'aiguille (43) par l'organe de déplacement en hauteur (44) de l'aiguille (43).

10. Dispositif de test selon la revendication 1, **caractérisé en ce que** qu'il comporte plusieurs entraînements de tête (11) avec différentes résolutions spatiales.
